# EUROPEAN PATENT APPLICATION

(11) **EP 4 333 031 A1**
(43) Date of publication of application: **06.03.2024**
(21) Application number: 22193880.6
(22) Date of filing: 05.09.2022
(51) Int. Cl.: H01L 21/60, H01L 23/544, H01L 23/31, H01L 21/56

(54) **A SEMICONDUCTOR DEVICE AND A METHOD OF ASSEMBLING A SEMICONDUCTOR DEVICE**

(71) Applicant: Nexperia B.V., 6534 AB Nijmegen (NL)
(72) Inventor: Ramalingam, Vegneswary, 71450 Seremban (MY)
(74) Representative: Pjanovic, Ilija

(57) **Abstract**

The present disclosure pertains to a semiconductor assembly device comprising a metal layer (5c), a first metal plate (5a), a second metal plate (5b), a metal pillar (3), an encapsulant (6), and a die structure (2) having a first terminal (2a) and a second terminal (2b), wherein the first terminal (2a) of the die structure (2) is in electrically contact with the metal layer (5c), wherein the metal pillar (3) is in electrical contact with the metal layer (5c), and where the second terminal (2b) of the die (2) is in contact with the first metal plate (5a) and the metal pillar (3) is in contact with the second metal plate (5b) and where between the die (2) and the metal pillar (3) and between the first metal plate (5a) and the second metal plate (5b) the encapsulant (6) is provided, and wherein at least one of the metal layer (5c), the first metal plate (5a) or the second metal plate (5b) are made of a sintered metal powder.

The disclosure also pertains to a method for manufacturing such semiconductor assembly device.

## Description

### TECHNICAL FIELD

The present disclosure relates to a high power semiconductor device in a form of stacked layers. A described method of assembling this device can be applied to form interconnections using variety of sinter-able grades of metal powder.

### BACKGROUND OF THE DISCLOSURE

Numerous methods of manufacturing layer wise structures are known in the state of the art, including laser sintering fabrication. Such methods are suitable for creating semiconductor devices, but most of them are complex and require post treatment processes.

The most common type of manufacturing powder-based structures is Selective Laser Sintering (SLS) that creates three-dimensional freeform objects directly from their CAD models. The object is created by selectively fusing thin layers of a powder with a scanning laser beam. Each scanned layer represents a cross section of the object's mathematically sliced CAD model.

An example of a method for using a directed beam of energy to selectively sinter metal powder to produce a part is disclosed in US2002/015654. This invention discloses a Solid Freeform Fabrication (SFF) method which comprises sequentially depositing layers of metal powder into a chamber with partial pressure atmosphere. Once a layer of powder is deposited, a scanning laser beam selectively fuses the layer into the desired shape. The process continues until a nonporous or fully dense part is completely fabricated, layer by layer. Disclosed method is destined for one direction growth of objects and it requires postprocessing to allow the produced part and leftover powder to cool under vacuum. The method is intended for powders of particles with diameters 10-100 µm made of Copper, Nickel and Cobalt base superalloys, superalloy cermet's, Titanium base alloys and monolithic high temperature metals such as Molybdenum.

Another prior art document no. US2016361843 discloses a laser sintering apparatus and method intended for manufacturing devices based on glass cement, preferably OLED display devices. An object of this disclosure is to provide a method, so as to prevent the occurrence of cracks or breakages in a cement due to a large shrinkage stress generated while sintering with laser beam. The document discloses an apparatus comprising three laser heads configured to sinter the cement with certain configuration of trajectory, speed, and laser power level.

Accordingly, it is a goal of the present disclosure to provide an improved method for laser sintering of metal materials intended for semiconductor devices. The method should allow sintering as an alternative option to form interconnects, eliminating the use of leadfree solder attach material, suitable for electronics, therefore eliminating a post treatment process associated to solder applications.

### SUMMARY OF THE DISCLOSURE

As a first example, a semiconductor device is proposed, comprising a metal layer, a first metal plate, a second metal plate, a metal pillar, an encapsulant, and a die with a first terminal and a second terminal. The first terminal of the die is in contact with the metal layer. The metal pillar is in contact with the metal layer. The second terminal of the die is in contact with the first metal plate. The metal pillar is in contact with the second metal plate. Between the die and the metal pillar and between the first metal plate and the second metal plate there is the encapsulant. At least one of the first metal plate or the second metal plate are made of a sintered metal powder.

Preferably the pillar is made of a sintered copper, silver, gold, or stainless steel powder.

Preferably the pillar is made of a sintered metal powder.

Preferably at least one of the metal layer, the first metal plate or the second metal plate are made of copper, copper with additives, silver, brass, aluminum, or carbon nanotubes.

Furthermore, the disclosure proposes a method of assembling a semiconductor device. In a first step a) a layer of a metal powder is provided on a semiconductor device assembly, with the semiconductor device assembly comprising a base with at least one perforation, at least one die with a first terminal and a second terminal, at least one metal pillar, and an encapsulant. The first terminal of the die is in contact with the base, the metal pillar is in contact with a base and the encapsulant is between the metal pillar and the die. The encapsulant is in the at least one perforation in the base. Additionally, the layer of a metal powder is provided in a way that it is in contact with the second terminal of the die, the metal pillar and the encapsulant.

A further step b) comprises sintering, with a laser, the layer of the metal powder to form a metal layer.

Preferably step a) and b) are performed multiple times alternately such that the formed sintered metal becomes thicker after every iteration.

Preferably the metal pillar is made during a step a0), which is performed before step a). The layer of the metal powder is provided on the base and the layer of the metal powder is sintered, preferably this step is performed multiple times to obtain the metal pillar with a height similar to a height of the die.

Preferably during step b) the laser sinters the metal powder such that it forms a letter, number, symbol, or pattern and after this step b) a step c) is performed, during which step an excessive metal powder is removed from the semiconductor device assembly.

It is preferred that the base is a mainframe and preferably the base is a mainframe and a carrier.

After the last sintering step b) related to the metal layer, a step e) is performed during which the carrier is removed and the semiconductor device assembly is turned upside down. After step e), during step f) a layer of a metal powder is provided, such that the metal powder is provided on the second terminal of the die, on the pillar and on the encapsulant. After this step f) a step g) is performed during which a laser is sintering the layer of the metal powder to form a first metal plate and a second metal plate.

Preferably steps f) and g) are performed multiple times alternately such that the formed sintered metal becomes thicker after every iteration.

Preferably after the last laser sintering step g), a step h) of singulation of each of the semiconductor devices is performed. Alternatively, after step g) but prior to step h) an additional step can be performed consisting of tin plating both sides of the exposed sintered metal surfaces.

Preferably the metal powder is made of particles having a diameter of 20-100 µm and preferably each layer of metal powder deposited during step a) and or step f) is one particle thick.

Preferably during steps b) and g), the metal powder is sintered at a temperature range of 170 °C - 400 °C and preferably the laser is sintering with a speed of 50-250 mm/s.

### BRIEF DESCRIPTION OF THE DRAWINGS

The disclosure will now be discussed with reference to the drawings, which show in:
Fig. 1a a metal pillar and a die provided on the base layer;
Fig. 1b assembled parts with an encapsulant in perforations in the base layer,
Fig. 1c assembled parts with a metal powder spread on top,
Fig. 1d assembled parts with the metal powder being submitted to a direct laser sintering,
Fig. 1e assembled parts with a solid metal layer formed laser sintering,
Fig. 1f a part turned upside down,
Fig. 1g assembled parts after removing the base with the metal powder spread and being submitted to the direct laser sintering,
Fig. 1h assembled parts with a solid metal plates formed after laser sintering,
Fig. 1i an optional tin plating process step prior to the singulation process of Fig. 1i,
Fig. 1j an assembled package being submitted to singulation process,
Fig. 2 a final package of a semiconductor device.

### DETAILED DESCRIPTION OF THE DISCLOSURE

For a proper understanding of the disclosure, in the detailed description below corresponding elements or parts of the disclosure will be denoted with identical reference numerals in the drawings.

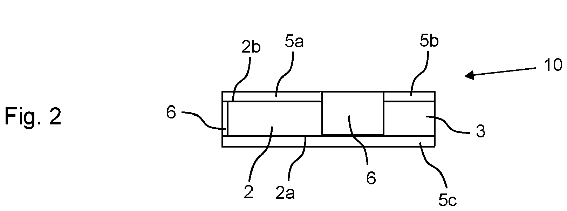

A semiconductor device package obtained with the method according to the disclosure, is depicted in Figure 2 and denoted with reference numeral 10. In general semiconductor device package 10 comprises a metal layer 5c, a first metal plate 5a, a second metal plate 5b, a metal pillar 3, an encapsulant 6, and a die 2 with a first terminal 2a and a second terminal 2b. The first terminal 2a of the die 2 is in contact with the metal layer 5c. The metal pillar 3 is in contact with the metal layer 5c. The second terminal 2b of the die 2 is in contact with the first metal plate 5a. The metal pillar 3 is in contact with the second metal plate 5b. Between the die 2 and the metal pillar 3 and between the first metal plate 5a and the second metal plate 5b there is the encapsulant 6. The metal layer 5c, the first metal plate 5a and the second metal plate 5b are made of a sintered metal powder. It also should be clear that the die 2 is a semiconductor with at least two terminals.

The pillar 3 preferably is made of copper, silver, gold or stainless steel.

In a preferred example of the disclosure, the pillar 3 is made of a sintered metal powder. In even more preferrable example the pillar 3 is made during the same process and there is no need to provide the pillars 3 being manufactured in another process. This solution simplified the whole manufacturing process.

The metal layer 5c, the first metal plate 5a and the second metal plate 5b may be made of copper, copper with additives, silver, brass, aluminum, or carbon nanotubes

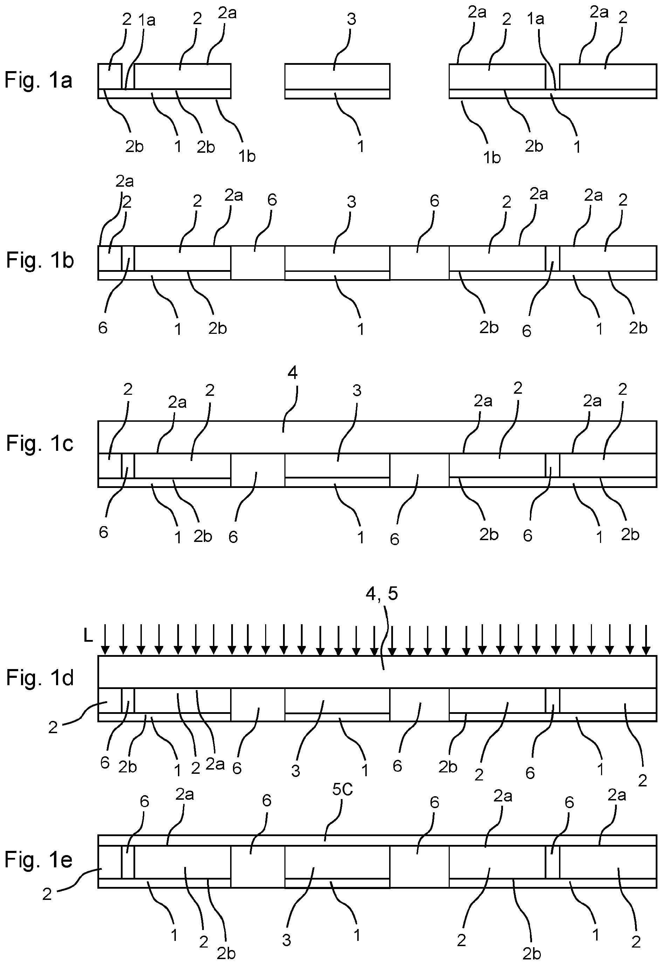

A method of assembling a semiconductor device according to the disclosure comprises at least two steps, denoted as step a) and step b). During step a), see fig. 1c, a layer of a metal powder 4 is provided on a semiconductor device assembly. The semiconductor device assembly comprises a base layer 1 having a first base layer side 1a and a second base layer side 1b and at least one perforation 1c. Furthermore, on the base layer 1 at least one die 2 with a first terminal 2a and a second terminal 2b is provided as well as at least one metal pillar 3. The first terminal 2a of the die 2 is in contact with the base layer 1. See fig. 1a. The metal pillar 3 is in contact with the base layer 1 and an encapsulant 6 is provided between the metal pillar 3 and the die 2. The encapsulant 6 is also in the perforations 1c of the base layer 1, see fig. 1b. The layer of a metal powder 4 is provided such that it is in contact with the second terminal 2b of the die 2, the metal pillar 3 and the encapsulant 6. During a step b) a sintering step is performed using laser light L with a laser and as a result, a metal layer 5c is formed during sintering of the layer of the metal powder 4 (fig. 1e).

A manufacturing method as presented with the present disclosure allows to avoid the use of mainframes and/or clips and provide elements with similar function made of a sintered metal.

In preferred embodiment the steps a) and b) are performed multiple times alternately. This allows for better control of the sintering process where each sintered metal layer has the same properties. A lower power laser may be used and each sintering step b) will take shorter time with thinner layers. A formed sintered metal is thicker after every iteration.

In yet another preferred embodiment the metal pillar 3 is made during a step a0), which is performed before the step a). The layer of the metal powder 4 is provided on the base and the layer of the metal powder 4 is sintered. This step a0) is preferably performed multiple times to obtain the metal pillar 4 with a height similar to a height of the die 2.

In another preferred example, during the step b) the laser sinters the metal powder 4 such that it forms a defined pattern and after this step, a step c) is performed, during which an excessive metal powder is removed from the semiconductor device assembly. The defined pattern includes, but is not limited to, a letter, number, symbol, or a plurality and/or mix of letters, numbers and symbols, or any other pattern such as lines, dots etc. This allows in particular to provide a semiconductor details during the same process.

According to beneficial examples of the disclosure, the base layer may be a mainframe or, in another example, a carrier 1.

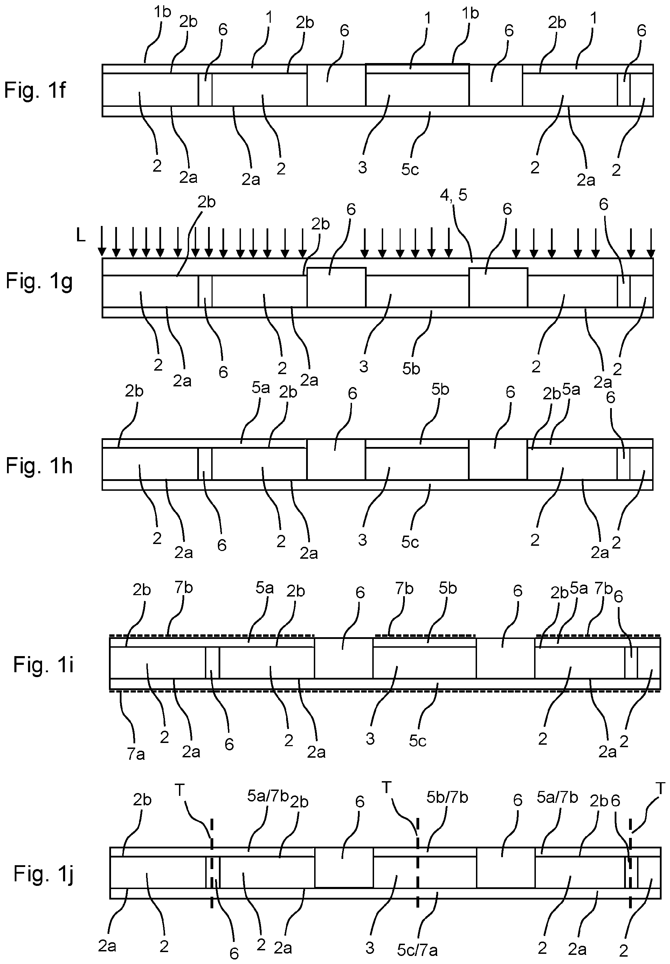

In yet another example, after the last step a) related to the forming of the metal layer 5c, a step e) is performed during which the carrier/base layer 1 is removed and the semiconductor device assembly is turned upside down. It should be noted that the carrier 1 may be removed after the semiconductor assemble has been turned upside down. The result of step e) and the turned upside down step is depicted in fig. 1f.

After step e), a step f) of providing a layer of a metal powder 4 is performed, wherein the metal powder 4 is provided on the first terminal 2a of the die 2, on the pillar 3 and on the encapsulant 6. After this step f), a step g) is performed, during which a laser is sintering the layer of the metal powder 4 to form a first metal plate 5a and a second metal plate 5b. Steps f) and g) are depicted in fig. 1g and 1h and may be performed multiple times alternately such that formed sintered metal 5a and 5b becomes thicker after every iteration.

In a preferred example after the last laser sintering step, a step h) of singulation of each semiconductor device is performed. The singulating step h) may comprise a trimming step T and results in individual semiconductor device packages 10 as shown in figs. 1j and 2.

In another example the metal powder is made of particles having a diameter of 20-100µm. During each depositing step a) and or f), each subsequent layer of metal powder 4 is preferably one particle thick.

In preferred embodiment during the steps b) and/or g) the metal powder is sintered in a temperature 170 °C - 400 °C. Preferably, the laser device is sintering with a speed of 50-250 mm/s.

Now, for illustrative purposes, an exemplary manufacturing process will be described with respect to Figures 1a-1j. All figures shows a cross-section of the assembly during the process.

On fig. 1a dies 2 and the pilar 3 are already placed on the carrier or base layer 1. The dies 2 are placed such that the first terminal 2a is in contact with the carrier/base layer 1. In all figures 1a-1j a small part of a whole assembly is presented and it should be clear that there are more metal pillars 3 and dies 2 placed or positioned on the base layer 1 in an alternating manner. As may be seen the dies 2 and the metal pillar 3 are separated from each other. These spaces and perforations 1c in the carrier 1 will be filled with the encapsulant 6, as shown in fig. 1b. In this embodiment the metal pilar 3 is made of copper.

After the encapsulation process of fig. 1b, the layer of the metal powder 4, preferably composed of copper particles in this embodiment, is provided on a top side of the intermediate assembly, who is on a side away or opposite from the base layer 1, where both the metal pilar 3 and the dies 2 are visible.

Fig. 1d shows a step of sintering, where a laser light L sinters the metal powder 4. It should be noticed that the laser light may sinter smaller surface areas of the metal powder 4 and it is not necessary to sinter all metal powder 4 at once.

Fig. 1e shows the assembly where on a first side there is the carrier 1, on other, opposite side there is the metal layer 5c connecting all second terminals 2b of the dies 2, the encapsulant 6 and the metal pillar(s) 3.

Fig. 1f shows the assembly after turning it upside down. Now the carrier/base layer 1 is on top of the assembly and after a subsequent process step e) the carrier 1 is completely removed, chemically or physically, from the assembly.

Fig. 1g shows the assembly, where during a further step f) metal powder 4 has been provided on a top side of the assembly, which is on the side where previously the carrier 1 was present or used to be, but has been removed during step e). The metal powder 4 is in contact with the first terminal 2a of the dies 2, the metal pilar 3 and the encapsulant 6. It should be noted that the encapsulant 6, after the carrier 1 has been removed, is protruding above a level of the metal pilar 3 and the dies 2. Fig. 1g shows, similarly to fig. 1d, the sintering of the metal assembly done by the laser light L.

Fig. 1h shows the assembly where a metal layer is sintered on fig. 1g forming the first metal plate 5a and the second metal plate 5b. In this embodiment the first metal plate 5a is in contact with the first terminals 2a of adjacent dies 2 and the second metal plate 5b is in contact with the metal pilar 3. Both the first metal plate 5a and the second metal plate 5b are separated from each other by a protruding portion of encapsulant 6. The person skilled in the art would know that such arrangement of the metal plates 5a and 5b depend on a particular semiconductor device project and may be changed as fit. In the present example the semiconductor device will have only two contacts in its final product, namely the first metal plate 5a, which is electrically connected to the first terminal 2a of the die 2 and the second metal plate 5b which is electrically connected to the metal layer 5c via the metal pillar 3. It should be noted that more dies, even with more terminals, and more contacts may be assembled during this process and the presented process is not limited to the semiconductor device with only one die 2 and two terminals 2a and 2b.

Fig. 1j shows the singulation of each semiconductor device 10 along dashed lines T. It should be understood that the assembly is a three dimension object and other cuts are made which are not presented in the figures.

Alternatively, after step g) (depicted in Fig. 1h) but prior to step h) (the singulation step of Fig. 1j) an additional step can be performed consisting of tin plating both sides of the exposed sintered metal surfaces 5a-5b-5c, thereby forming a thin layer of tin material. Both thin layers are denoted in an exaggerated, emphasized manner by means of the dashed lines 7a-7b in Fig. 1i.

Fig. 2 shows a final product which is the semiconductor assembly device or package 10. The package 10 has on one side the metal layer 5c connected to the first terminal 2a of the die 2 and the metal pillar 3, with the die 2 and the pillar 3 being separated by a portion of encapsulant 6. On the other side of the package 10 are provided the first metal plate 5a connected to the second terminal 2b, and the second metal plate 5b connected to the metal pillar 6. Both the first metal plate 5a and the second metal plate 5b are electrically separated from each other by means of the portion of the encapsulant 6. On the sides of the package 10, the pilar 3 and encapsulant 6 is visible / exposed. It should be noted that in this example the die 2, in the final product, is not visible.

The disclosed example of the disclosure is illustrative only and in no way limiting the invention as claimed.

A method based on the direct metal laser sintering overcomes the predicament of High Lead solder application in clip bonding packages. By deploying this method, dispensing/stencil print, reflow and flux cleaning process can be eliminated. The disclosure can also be applied to form interconnects using a variety of sinter-able grades of metal powder.

### LIST OF REFERENCE SYMBOLS USED

- 1: - Carrier / base layer
- 1a: - First side of base layer
- 1b: - Second side of base layer
- 2: - Die
- 2a: - First terminal
- 2b: - Second terminal
- 3: - Metal pillar
- 4: - Metal powder
- 5: - Sintered metal powder
- 5a: - First metal plate
- 5b: - Second metal plate
- 5c: - Metal layer
- 6: - Encapsulant
- 7a-7b: - Thin layers of tin material
- 10: - Semiconductor assembly device / package
- L: - Laser light
- T: - Singulation section

## Claims

1. A semiconductor assembly device comprising a metal layer (5c), a first metal plate (5a), a second metal plate (5b), a metal pillar (3), an encapsulant (6), and a die structure (2) having a first terminal (2a) and a second terminal (2b), wherein the first terminal (2a) of the die structure (2) is in electrically contact with the metal layer (5c), wherein the metal pillar (3) is in electrical contact with the metal layer (5c), and where the second terminal (2b) of the die (2) is in contact with the first metal plate (5a) and the metal pillar (3) is in contact with the second metal plate (5b) and where between the die (2) and the metal pillar (3) and between the first metal plate (5a) and the second metal plate (5b) the encapsulant (6) is provided, and wherein at least one of the metal layer (5c), the first metal plate (5a) or the second metal plate (5b) are made of a sintered metal powder.

2. The semiconductor device according to claim 1, wherein the pillar (3) is made of copper, silver, gold or stainless steel.

3. The semiconductor device according to claim 1 or 2, wherein the pillar (3) is made of a sintered metal powder.

4. The semiconductor device according to anyone of the previous claims, wherein at least one of the metal layer (5c), the first metal plate (5a) or the second metal plate (5b) are made of copper, copper with additives or silver.

5. A method of assembling a semiconductor device as outlined in one or more of the claims 1-4, the method comprising the steps of:
a. providing a base layer (1) having a first base layer side (1a) and a second base layer side (1b) and at least one perforation (1c), at least one die structure (2) having a first terminal (2a) and a second terminal (2b), the at least one die structure (2) being mounted with its second terminal (2b) on the first base layer side (1a) of the base layer (1), and at least one metal pillar (3) mounted on the first base layer side (1a) of the base layer (1) and at some distance from the at least one die structure (2),
b. providing an encapsulant material (6) on the first base layer side (1a) and in the perforation and between the metal pillar (3) and the at least one die structure (2), thereby forming an encapsulant structure,
c. providing a layer of a metal powder (4) on the encapsulant structure such that the metal powder is in contact with the first terminal (2a) of the die structure (2), the metal pillar (3) and the encapsulant material (6);
d. sintering, with laser light radiation (L), the layer of the metal powder (4) to form a metal layer (5c).

6. The method according to claim 5, wherein steps c and d are performed multiple times alternately such that the formed sintered metal becomes thicker after every iteration.

7. The method according to claim 5 or 6, wherein a step a0, being performed before step a, comprises the step of forming the metal pillar (3) on the first surface side (1a) of the base layer (1) by
a0-1 applying a layer of metal powder (3) on the first surface side (1a) of the base layer (1) and
a0-2 sintering the layer of the metal powder (3), and
a0-3 repeating sub steps a0-1 and a0-2 multiple times to obtain the metal pillar (4) with a height similar to a height of the die structure (2).

8. The method according to anyone of the previous claims 5-7, wherein the sintering step d comprises the step of forming the sintered metal layer (5c) into a letter, a number, a symbol, or a pattern and is followed by the step of removing excessive metal powder (4).

9. The method according to anyone of the claims 5-8, wherein the base layer is a mainframe.

10. The method according to anyone of claims 5-8, wherein the base layer is a carrier (1).

11. The method according to anyone of claims 5-10, further comprising the steps, performed after step d, of
e. removing the base layer (1) from the encapsulant structure;
f. turning the encapsulant structure upside down and
g. providing a layer of a metal powder (4) on the encapsulant structure such that the metal powder (4) is provided on the second terminal of the die (2), on the pillar (3) and on the encapsulant (6), and
h. sintering, with laser light radiation (L), the layer of the metal powder (4) to form a first metal plate (5a) and a second metal plate (5b).

12. The method according to claim 11, wherein step g and h are performed multiple times alternately such that the formed sintered metal becomes thicker after every iteration.

13. The method according to claim 11 or 12, further comprising the step, after the last sintering step h, of
i. singulating each semiconductor assembly device.
